Europäisches Patentamt

European Patent Office

Office européen des brevets

(19)

(11) Veröffentlichungsnummer: **0 152 972**
**B1**

(12) **EUROPÄISCHE PATENTSCHRIFT**

(45) Veröffentlichungstag der Patentschrift: 28.11.90

(51) Int. Cl.⁵: **H 01 L 23/48**

(21) Anmeldenummer: **85200051.2**

(22) Anmeldetag: **21.01.85**

(54) **Kontaktierungssystem für 2-polige elektronische Bauelemente, insbesondere Halbleiterbauelemente.**

(30) Priorität: **28.01.84 DE 3402970**

(43) Veröffentlichungstag der Anmeldung:
**28.08.85 Patentblatt 85/35**

(45) Bekanntmachung des Hinweises auf die
Patenterteilung:
**28.11.90 Patentblatt 90/48**

(84) Benannte Vertragsstaaten:
**DE FR GB IT NL**

(56) Entgegenhaltungen:
EP-A-0 084 859
DE-A-2 643 147
DE-A-2 938 096
DE-A-3 122 387
DE-B-2 608 813
US-A-4 173 768

(73) Patentinhaber: **Philips Patentverwaltung GmbH**
**Wendenstrasse 35 Postfach 10 51 49**
**D-2000 Hamburg 1 (DE)**
(84) **DE**

(73) Patentinhaber: **N.V. Philips'**
**Gloeilampenfabrieken**
**Groenewoudseweg 1**
**NL-5621 BA Eindhoven (NL)**
(84) **FR GB IT NL**

(72) Erfinder: **Zeile, Heinrich, Dr. rer. nat.**
**Grosse Brunnenstrasse 23**
**D-2000 Hamburg 50 (DE)**
Erfinder: **Sauermann, Heinz, Dipl.-Phys.**
**Rotdornstieg 15**
**D-2083 Halstenbek (DE)**

(74) Vertreter: **David, Günther M. et al**
**Philips Patentverwaltung GmbH Wendenstrasse**
**35 Postfach 10 51 49**
**D-2000 Hamburg 1 (DE)**

Courier Press, Leamington Spa, England.

EP 0 152 972 B1

## Beschreibung

Die Erfindung betrifft zweipolige elektronische Bauelemente, insbesondere Halbleiterbauelemente, mit einem DruckKontaktierungssystem, bei dem ein an mindestens einer von zwei einander gegenüberliegenden Hauptflächen mit einer dicken Druckkontaktschicht versehener Bauelementenkörper zwischen zwei durch ein Gehäuse 4 mechanisch verbundenen, elektrisch mit der Druckkontaktschicht in Kontakt stehenden Kontaktkörpern unter Druck gehalten ist.

Halbleiterdioden mit einem solchen Druck-Kontaktierungssystem sind z.B. aus der DE—A—26 43 147, bekannt. Solche Halbleiterdioden enthalten in einem Weichglasgehäuse einen Bauelementenkörper (Siliciumkristall) der auf beiden Hauptseiten metallisiert ist. Abgesehen von Haftschichten verwendet man hierfür üblicherweise auf der Kristallvorderseite eine großflächige, relativ dicke Silberschicht (Dicke etwa 5 bis 20% der Dicke des Bauelementenkörpers, Durchmesser über 100 µm) und auf der Rückseite des Bauelementenkörpers eine vollflächige, dünne Silberschicht. Der Siliciumkörper wird dann in ein Glasröhrchen eingeschmolzen, wobei zwei Anschlußdrähte mit ihren Stirnseiten die genannten Silberschichten planaufliegend berühren. Erhitzt man bis zum Erweichungspunkt des Weichglases (ca. 700°C) so benetzt das Weichglas die Mantelflächen der Anschlußdrähte und beim Abkühlen schrumpft das Weichglas ein wenig, so daß die Anschlußdrähte gegen die genannten Silberschichten gepreßt werden.

Dadurch wird der Bauelementenkörper durch Druckkontaktierung mit den Anschlußdrähten elektrisch verbunden. Beim Einschmelzen fangen die Silberschichten die auftretenden Kräfte dadurch ab, daß sich das Silber irreversibel verformt.

Will man ein so kontaktiertes Bauelement bei relativ hohen Temperaturen und in häufigen Temperaturwechseln arbeiten lassen, so ergibt sich einmal das Problem, daß die dicke und großflächige Silbermetallisierung eine wesentlich größere Wärmeausdehnung hat als der damit bedeckte Siliciumkristall. Bei häufigen, starken Temperaturwechseln können Scherspannungen an der Grenzfläche zwischen dem Silicium und dem Silber zu so starken irreversiblen Verformungen der Metallisierung führen, daß das Bauelement defekt wird. Weiter ist der Temperaturwechsel auch von Druckänderungen in axialer Richtung begleitet, so daß die Metallisierung eine axiale Kriechverformung erfahren kann. Schließlich kann der resultierende Druckabbau die Verbindung zwischen der Metallisierung und dem angrenzenden Anschlußdraht mechanisch und elektrisch auftrennen.

Aus der DE—A—31 22 387 ist eine Glasdiode bekannt, die mit Titan und Kupfer metallisiert ist. Weiter ist noch eine Zinnschicht vorhanden, die beim Einschmelzen eine Lötverbindung Kupfer/Zinn/Kupfer herstellt. Der mechanische, sonst übliche Druckkontakt ist also bei diesem Bauelement durch eine Lötverbindung ersetzt. Ähnlich ist das aus der DE—A—26 43 147 bekannte Bauelement aufgebaut, bei dem eine Gold/Germanium-Legierung auf Silber verwendet wird.

Bei diesen beiden bekannten Bauelementen dürfte gegenüber dem üblichen Druckkontakt die Gefahr von Kontaktunterbrechungen verringert sein. Dem oben erläuterten Problem der lateralen Verformungen wird jedoch nicht abgeholfen.

Der Erfindung liegt daher die Aufgabe zugrunde, ein Kontaktierungssystem der eingangs genannten Art so auszugestalten, daß es sich bei Arbeitstemperaturen bis zu 300°C und häufigen Temperaturwechseln mechanisch und elektrisch stabil verhält.

Diese Aufgabe wird erfindungsgemäß dadurch gelöst, daß die Druckkontaktschicht auf mindestens einer der Hauptflächen des Bauelementenkörpers in mindestens zwei voneinander getrennte Kontaktblöcke unterteilt ist, wobei der maximale Durchmesser der Kontaktblöcke 2 an der Grenzfläche zum Bauelementenkörper 1 kleiner als ein kritischer Durchmesser ist, so daß bei einem Temperaturwechsel die Scherspannungen an der Grenzfläche keine bleibenden Verformungen der Kontaktblöcke 2 und/oder des Bauelementenkörpers bewirken.

Ein solches Kontaktierungssystem kann einfach mit den bei der Herstellung von Halbleiterbauelementen üblichen Techniken hergestellt werden und ist bis zu Arbeitstemperaturen von mindestens 300°C und häufigen Temperaturwechseln mechanisch und elektrisch stabil.

Weitere Ausgestaltungen der Erfindung ergeben sich aus den Unteransprüchen.

Das Metallisierungssystem nach der Erfindung läßt sich in einem Weichglasgehäuse gut bis zu Temperaturen von etwa 300°C verwenden. Die Druckkontaktschicht ist in mehrere, vorzugsweise 3 oder 4 nebeneinander stehende Kontaktblöcke aufgeteilt. Zur Vermeidung von lateralen Verformungen ist es dabei wichtig, daß der maximale Durchmesser der Kontaktblöcke an der Grenzfläche zum Bauelementenkörper kleiner als ein bestimmter kritischer Durchmesser ist. Dieser Durchmesser ergibt sich aus der Bedingung, daß während eines Temperaturwechsels die Scherspannung an der Grenzfläche noch nicht die Fließgrenze des Metalls erreichen und/oder Kristallausbrüche bewirken. Die Scherspannungen steigen mit einer Vergrößerung des Durchmessers an, während die materialspezifische Fließgrenze bei steigender Temperatur sinkt. Für ein Arbeitstemperaturintervall von 0°C bis 300°C und für Kontaktblöcke aus galvanisiertem Silber auf Silicium beträgt der kritische maximale Durchmesser etwa 100 µm.

Die Summe der Höhen der Kontaktblöcke auf beiden Hauptflächen des Bauelementenkörpers beträgt vorzugsweise mehr als 1/3 dessen Dicke. Sie ist dabei vorzugsweise so gewählt, daß sich Wärmeausdehnungen des Bauelementenkörpers, der Kontaktblöcke und des die Kontaktkörper mechanisch miteinander verbindenden (Weichglas-)Gehäuses in axialer Richtung kompensieren. Damit wird der axiale Druck in diesen drei Teilen des Kontaktierungssystems temperaturunabhängig.

Die Kontaktblöcke, die quader-, säulen- oder halbkugelförmig ausgebildet sein können, stehen auf einer dünnen, als Kontaktschicht wirkenden Metallschicht, die alle Kontaktblöcke elektrisch mit dem zu kontaktierenden Teil des Bauelementenkörpers verbinden.

Auf die den Kontaktkörpern zugewandte Fläche der Kontaktblöcke ist vorzugsweise eine Verbindungsschicht aufgebracht, die dazu dient, während des Herstellens (z.B. Einschmelzen in eine Weichglasumhüllung bei ca. 700°C) durch Weichlöten, Hartlöten oder Diffusionsschweißen eine Verbindung zwischen den Kontaktblöcken und den Kontaktkörpern herzustellen. Eine solche Verbindung ist mechanisch und elektrisch dauerhaft in einem Arbeitstemperaturbereich von 0°C bis 300°C. Die Kontaktblöcke können z.B. aus Nickel, die Verbindungsschicht aus Gold und die Kontaktkörper aus Kupfer bestehen.

Zwischen den Kontaktblöcken und der Verbindungsschicht kann noch eine sogenannte Stopschicht angebracht werden um sicherzustellen, daß sich das Material der Verbindungsschicht bevorzugt in Richtung auf die Kontaktkörper die an der der Verbindung zugewandten Fläche vorzugsweise aus Kupfer bestehen, lenkt. In diesem Falle können z.B. die Kontaktblöcke aus Kupfer, die Stopschicht aus Kobalt und die Verbindungsschicht und die Kontaktkörper ebenfalls aus Gold bzw. Kupfer bestehen.

Ein Ausführungsbeispiel der Erfindung wird im folgenden anhand der beigefügten Zeichnungen näher erläutert.

Es zeigen:

Fig. 1 einen Längsschnitt durch ein in einem Weichglasgehäuse angeordnetes Halbleiterbauelement,

Fig. 2 einen Schnitt durch den Halbleiterkörper des Bauelementes nach Fig. 1 und

Fig. 3 eine Draufsicht auf eine der Hauptflächen dieses Halbleiterkörpers.

Die Figuren sind in Dickenrichtung nicht maßstabsgerecht.

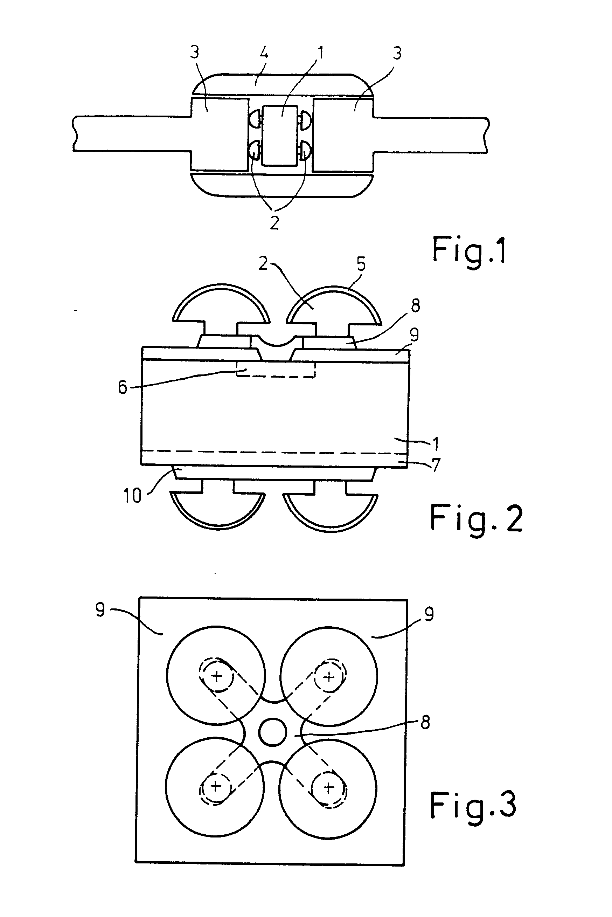

Das in Fig. 1 im Schnitt dargestellte Halbleiterbauelement ist ein Temperatursensor aus einkristallinem Silicium wie er z.B. in der DE—A—30 41 818 beschrieben ist. Das Bauelement arbeitet nach dem Stromausbreitungsprinzip und der Halbleiterkörper 1 ist in ein Weichglasgehäuse nach der Norm DO 34 eingesetzt, das aus zwei Kontaktkörpern 3 die gleichzeitig als Anschlußdrähte dienen und einem Gehäuse 4 aus Weichglas besteht. Der Siliciumkristall 1 trägt auf beiden Hauptflächen Kontaktblöcke 2, die mit den Kontaktkörpern 3 in Druckkontakt stehen. Der Siliciumeinkristall 1 ist etwa 250 µm dick und hat eine Fläche von etwa 500 × 500 µm. Die zu kontaktierende Zone 6 auf der oberen Hauptfläche des Kristalls 1 erstreckt sich nur in deren Mitte. Der restliche Teil dieser Fläche ist mit einer Isolations- und Passivierungsschicht 9 aus Siliciumoxid und Siliciumnitrid abgedeckt. Auf dieser Schicht 9 und auf dem freiliegenden, zu kontaktierenden Teil dieser Fläche oberhalb der Zone 6 erstreckt sich eine kreuzförmige Kontaktschicht 8 aus Titan/Wolfram (je 50 Atom%) von 0,4 µm Dicke und einer darauf liegenden Goldschicht von 0,6 µm Dicke.

Die untere Hauptfläche des Siliciumkristalls 1 wird ganzflächig kontaktiert, sie trägt daher keine Isolationsschicht sondern nur eine quadratische Kontaktschicht 10 in gleicher Zusammensetzung wie die Schicht 8 auf der oberen Hauptfläche.

Bei einem so weit hergestellten System wird dann auf jede der Hauptflächen eine Lackmaske aufgebracht. Sie ist 4 µm dick und weist 4 Fenster von je 60 µm Durchmesser auf, die in einem Abstand von 210 µm zueinander liegen.

Unter dem Schutz dieser Lackmaske wird dann galvanisch Silber niedergeschlagen, so daß sich pilzförmige Kontaktblöcke 2 bilden deren Höhe etwa 60 µm beträgt und die einen größten Durchmesser von 180 µm haben. Auf diesen pilzförmigen Kontaktblöcken wird dann eine 5 µm dicke, aus Zinn bestehende Verbindungsschicht 5 abgeschieden und anschließend die (in der Figur nicht dargestellte Lackmaske) abgelötet.

Die so mit Kontaktblöcken 2 versehenen Siliciumkristalle 1 werden dann bei einer Temperatur von etwa 670°C in das in Figur 1 dargestellte Weichglasgehäuse eingeschmolzen. Dabei legiert die Zinnschicht 5 mit dem Kupfer der Kontaktkörper 3 und mit dem Silber der Kontaktblöcke 2. Die Kontaktkörper 3 brauchen selbstverständlich nicht völlig aus Kupfer zu bestehen, es genügt, wenn sie in der mit den Kontaktblöcken 2 in Verbindung stehenden Stirnflächen aus Kupfer sind.

## Patentansprüche

1. Zweipoliges elektronisches Bauelement, insbesondere Halbleiterbauelement, mit einem Druck-Kontaktierungssystem, bei dem ein an mindestens einer von zwei einander, gegenüberliegenden Hauptflächen mit einer dicken Druckkontaktschicht versehener Bauelementenkörper (1) zwischen zwei durch ein Gehause (4) mechanisch verbundenen elektrisch mit der Druckkontaktschicht in Kontakt stehenden Kontaktkörpern (3) unter Druck gehalten ist, dadurch gekennzeichnet, daß die Druckkontaktschicht auf mindestens einer der Hauptflächen des Bauelementenkörper (1) in mindestens zwei voneinander getrennte Kontaktblöcke (2) unterteilt ist, wobei der maximale Durchmesser der Kontaktblöcke (2) an der Grenzfläche zum Bauelementenkörper (1) kleiner als kritscher Durchmesser ist, so daß bei einem Temperaturwechsel die Scherspannungen an der Grenzfläche keine bleibenden Verformungen der Kontaktblöcke (2) und/oder des Bauelementenkörpers bewirken.

2. Zweipoliges elektronisches Bauelement nach Anspruch 1, dadurch gekennzeichnet, daß die Kontaktblöcke (2) gleichmäßig über die Hauptfläche des Bauelementenkörpers (1) verteilt angeordnet sind.

3. Zweipoliges elektronisches Bauelement nach Anspruch 1, dadurch gekennzeichnet, daß die Kontaktblöcke quader-, säulen-, halbkugel- oder pilzförmig ausgebildet sind.

4. Zweipoliges elektronisches Bauelement nach Anspruch 1, dadurch gekennzeichnet, daß zwischen den Kontaktblöcken (2) und dem zu kontaktierenden Teil der Hauptfläche des Bauelementenkörpers eine Kontaktschicht (8) angeordnet ist.

5. Zweipoliges elektronisches Bauelement nach Anspruch 1, dadurch gekennzeichnet, daß auf beiden Hauptflächen des Bauelementenkörpers (1) je 4 pilzförmige Kontaktblöcke (2) angeordnet sind.

6. Zweipoliges elektronisches Bauelement nach Anspruch 1, dadurch gekennzeichnet, daß die Gesamtdicke der Kontaktblöcke (2) auf beiden Hauptflächen des Bauelementenkörpers (1) mindestens ein Drittel der Dicke des Bauelementenkörpers (1) beträgt.

7. Zweipoliges elektronisches Bauelement nach Anspruch 6, dadurch gekennzeichnet, daß die Gesamtdicke der Kontaktblöcke (2) so gewählt ist, daß sich die Wärmeausdehnungen des Bauelementenkörpers (1), der Kontaktblöcke (2) und des Gehäuses (4) in axialer Richtung kompensieren.

8. Zweipoliges elektronisches Bauelement nach Anspruch 1 mit einem Bauelementenkörper aus Silicium und Kontaktblöcken aus Silber, dadurch gekennzeichnet, daß der maximale Durchmesser der Kontaktblöcke (2) kleiner 100 µm ist.

9. Zweipoliges elektronisches Bauelement nach Anspruch 1, dadurch gekennzeichnet, daß die Kontaktblöcke (2) mit einer Verbindungsschicht (5) aus einem solchen Material bedeckt sind, daß bei einer Temperatur kleiner 700°C zwischen den Kontaktblöcken (2) und den Kontaktkörpern (3) eine Verbindung durch Löten oder Diffusionsschweißen gebildet wird, die im Arbeitstemperaturbereich des Bauelementes stabil ist.

10. Zweipoliges elektronisches Bauelement nach Anspruch 9, dadurch gekennzeichnet, daß zwischen der Verbindungsschicht (5) und den Kontaktblöcken (2) eine Stopschicht angebracht ist, die die Vermischung zwischen der Verbindungsschicht (5) und den Kontaktblöcken (2) hemmt.

11. Zweipoliges elektronisches Bauelement nach einem der vorangehenden Ansprüche, dadurch gekennzeichnet, daß der Bauelementenkörper (1) aus Silicium besteht.

12. Zweipoliges elektronisches Bauelement nach einem der vorangehenden Ansprüche, dadurch gekennzeichnet, daß das Gehäuse (4) aus Weichglas besteht.

13. Zweipoliges elektronisches Bauelement nach einem der vorangehenden Ansprüche, dadurch gekennzeichnet, daß die Kontaktblöcke (2) aus Silber, die Verbindungsschicht (5) aus Zinn und die Kontaktkörper (3) aus Kupfer bestehen.

14. Zweipoliges elektronisches Bauelement nach einem der Ansprüche 1 bis 12, dadurch gekennzeichnet, daß die Kontaktblöcke aus Nickel, die Verbindungsschicht (5) aus Gold und die Kontaktkörper (3) aus Kupfer bestehen.

15. Zweipoliges elektronisches Bauelement nach einem der Ansprüche 1 bis 12, dadurch gekennzeichnet, daß die Kontaktblöcke (2) aus Kupfer, die Stopschicht aus Kobalt, die Verbindungsschicht (5) aus Gold und die Kontaktkörper (3) aus Kupfer bestehen.

**Revendications**

1. Composant électronique à deux pôles, en particulier composant semi-conducteur, comportant un système de contact à pression, dans lequel un corps de composant (1) pourvu d'une épaisse couche de contact à pression sur au moins une de deux faces principales opposées l'une à l'autre, est maintenu sous pression entre deux corps de contact (3) reliés mécaniquement par un boîtier (4), qui sont en contact électrique avec la couche de contact à pression, caractérisé en ce que la couche de contact à pression est divisée, sur au moins une des faces principales du corps de composant (1), en au moins deux blocs de contact (2) séparés l'un de l'autre, le diamètre maximum des blocs de contact (2) à l'interface avec le corps de composant (1) étant inférieur à un diamètre critique, de sorte que lors d'une fluctuation de température, les tensions de cisaillement à l'interface n'entraînent pas de déformation permanente des blocs de contact (2) et/ou du corps de composant.

2. Composant électronique à deux pôles suivant la revendication 1, caractérisé en ce que les blocs de contact (2) sont uniformément répartis sur la face principale du corps de composant (1).

3. Composant électronique à deux pôles suivant la revendication 1, caractérisé en ce que les blocs de contact (2) sont de configuration quadrangulaire, colonnaire, hémisphérique ou en champignon.

4. Composant électronique à deux pôles suivant la revendication 1, caractérisé en ce qu'une couche de contact (8) est disposée entre les blocs de contact (2) et la partie servant au contact de la face principale du corps du composant.

5. Composant électronique à deux pôles suivant la revendication 1, caractérisé en ce que 4 blocs de contact en forme de champignon (2) sont disposés sur les deux faces principales du corps de composant (1).

6. Composant électronique à deux pôles suivant la revendication 1, caractérisé en ce que l'épaisseur totale des blocs de contact (2) sur les deux faces principales du corps de composant (1) est au moins égale au tiers de l'épaisseur du corps de composant (1).

7. Composant électronique à deux pôles suivant la revendication 6, caractérisé en ce que l'épaisseur totale des blocs de contact (2) est choisie telle que les dilatations thermiques du corps de composant (1), des blocs de contact (2) et du boîtier (4) se compensent dans le sens axial.

8. Composant électronique à deux pôles suivant la revendication 1, comportant un corps de composant en silicium et des blocs de contact en argent, caractérisé en ce que le diamètre maximum des blocs de contact (2) est inférieur à 100 μm.

9. Composant électronique à deux pôles suivant la revendication 1, caractérisé en ce que les blocs de contact (2) sont recouverts d'une couche de liaison (5) en une matière telle qu'à une température inférieure à 700°C il s'établit entre les blocs de contact (2) et les corps de contact (3), par brasage ou soudage par diffusion, une liaison qui est stable dans le domaine de température de travail du composant.

10. Composant électronique à deux pôles suivant la revendication 9, caractérisé en ce qu'une couche d'arrêt qui entrave le mélange de la couche de liaison (5) avec les blocs de contact (2) est disposée entre la couche de liaison (5) et les blocs de contact (2).

11. Composant électronique à deux pôles suivant l'une quelconque des revendications précédentes, caractérisé en ce que le corps de composant (1) est en silicium.

12. Composant électronique à deux pôles suivant l'une quelconque des revendications précédentes, caractérisé en ce que le boîtier (4) est en verre tendre.

13. Composant électronique à deux pôles suivant l'une quelconque des revendications précédentes, caractérisé en ce que les blocs de contact (2) sont en argent, la couche de liaison (5) est en étain et les corps de contact (3) sont en cuivre.

14. Composant électronique à deux pôles suivant l'une quelconque des revendications 1 à 12, caractérisé en ce que les blocs de contact sont en nickel, la couche de liaison (5) est en or et les corps de contact (3) sont en cuivre.

15. Composant électronique à deux pôles suivant l'une quelconque des revendications 1 à 12, caractérisé en ce que les blocs de contact (2) sont en cuivre, la couche d'arrêt est en cobalt, la couche de liaison (5) est en or et les corps de contact (3) sont en cuivre.

**Claims**

1. A 2-pole electronic chip, in particular a semiconductor component, having a pressure contacting system, in which a chip body provided with a thick pressure contact layer on at least one of two mutually opposite main surfaces is kept under pressure between two contact members (2) which are mechanically joined by a housing (4) and which are in electrical contact with the pressure contact layer, characterized in that the pressure contact layer is subdivided into at least two mutually separated contact blocks (2) on at least one of the main surfaces of the chip body (1), the maximum diameter of the contact blocks (2) at the interface with the chip body (1) being smaller than a critical diameter, so that shear stresses at the interface do not cause permanent deformations of the contact blocks (2) and/or the chip body in the case of a temperature change.

2. A 2-pole electronic chip as claimed in Claim 1, characterized in that the contact blocks (2) are evenly distributed over the main surface of the chip body (1).

3. A 2-pole electronic chip as claimed in Claim 1, characterized in that the contact blocks (2) have a cuboid, column, hemispherical, or mushroom shape.

4. A 2-pole electronic chip as claimed in Claim 1, characterized in that a contact layer (8) is provided between the contact blocks (2) and the portion of the main surface of the chip body which is to be contacted.

5. A 2-pole electronic chip as claimed in Claim 1, characterized in that 4 mushroom-shaped contact blocks (2) are arranged on both main surfaces of the chip body (1).

6. A 2-pole electronic chip as claimed in Claim 1, characterized in that the total thickness of the contact blocks (2) on both main surfaces of the chip body (1) is at least $\frac{1}{3}$ of the thickness of the chip body (1).

7. A 2-pole electronic chip as claimed in Claim 6, characterized in that the total thickness of the contact blocks (2) is so chosen that the heat expansions of the chip body (1), of the contact blocks (2), and of the housing (4) compensate one another in axial direction.

8. A 2-pole electronic chip as claimed in Claim 1, having a chip body of silicon and contact blocks of silver, characterized in that the maximum diameter of the contact blocks (2) is smaller than 100 μm.

9. A 2-pole electronic chip as claimed in Claim 1, characterized in that the contact blocks (2) are covered with a connecting layer (5) made of such a material that at a temperature below 700°C a soldering, brazing, or diffusion-welding connection is effected between the contact blocks (2) and the contact members (3), which connection is stable in the operating temperature range of the chip.

10. A 2-pole electronic chip as claimed in Claim 9, characterized in that a stop layer is provided between the connecting layer (5) and the contact blocks (2), which stop layer inhibits the intermixing between the connecting layer (5) and the contact blocks (2).

11. A 2-pole electronic chip as claimed in any one of the preceding Claims, characterized in that the chip body (1) consists of silicon.

12. A 2-pole electronic chip as claimed in any one of the preceding Claims, characterized in that the housing (4) consists of soft glass.

13. A 2-pole electronic chip as claimed in any one of the preceding Claims, characterized in that the contact blocks (2) consist of silver, the connecting layer (5) consit of tin, and the contact members (3) consist of copper.

14. A 2-pole electronic chip as claimed in any one of the Claims 1 to 12, characterized in that the contact blocks consist of nickel, the connecting layer (5) consists of gold, and the contact member (3) consist of copper.

15. A 2-pole electronic chip as claimed in any one of the Claims 1 to 12, characterized in that the contact blocks (2) consist of copper, the stop layer consists of cobalt, the connecting layer (5) consists of gold, and the contact member (3) consists of copper.

Fig.1

Fig.2

Fig.3